# EUROPEAN PATENT APPLICATION

(11) **EP 4 625 140 A1**
(43) Date of publication of application: **01.10.2025**
(21) Application number: 25165728.4
(22) Date of filing: 24.03.2025
(51) Int. Cl.: G06F 7/533, G06F 7/53, G06F 5/00, G06F 30/30, G06G 7/16

(54) **MIXED-RADIX MULTIPLIER CIRCUIT**

(30) Priority: 29.03.2024 US 202418622048
(71) Applicant: Altera Corporation, San Jose, CA 95134 (US)
(72) Inventor: LANGHAMMER, Martin, Alderbury, sp53AB (GB); PASCA, Bogdan, 31000 Toulouse (FR); KUCHERENKO, Igor Viktorovich, San Jose, 95134 (US)
(74) Representative: 2SPL Patentanwälte PartG mbB

(57) **Abstract**

Integrated circuit devices, methods, and circuitry for an efficient multiplier are provided. Multiplier circuitry to multiply a multiplicand value with a multiplier value may include input circuitry, mixed-radix partial product generation circuitry, and partial product addition circuitry. The input circuitry may receive the multiplicand value and the multiplier value. The mixed-radix partial product generation circuitry may generate partial products that include a first radix partial product according to a first radix coding and a second radix partial product according to a second radix coding. The partial product addition circuitry may add the partial products to generate a product of the multiplicand value and multiplier value..

## Description

### BACKGROUND

The present disclosure relates generally to integrated circuit (IC) devices such as processors, application specific integrated circuits (ASICs), and programmable logic devices (PLDs) that include a hardened multiplier circuit with multiple radix partial products to provide area- and/or power-efficient multiplication.

This section is intended to introduce the reader to various aspects of art that may be related to various aspects of the present disclosure, which are described and/or claimed below. This discussion is believed to be helpful in providing the reader with background information to facilitate a better understanding of the various aspects of the present disclosure. Accordingly, it may be understood that these statements are to be read in this light, and not as admissions of prior art.

Integrated circuits are ubiquitous in modern electronics. Many integrated circuit operations involve multiplying two values to obtain a product using a multiplier circuit. Artificial intelligence (AI) in particular involves so many multiplier instances that there may be millions of multiplier circuits or more per device. Indeed, multipliers are often the most expensive digital portion of modern arithmetic circuits, which are used in cryptography, AI, floating point compute for high performance computing (HPC), and more.

### BRIEF DESCRIPTION OF THE DRAWINGS

Various aspects of this disclosure may be better understood upon reading the following detailed description and upon reference to the drawings in which:
FIG. 1 illustrates a block diagram of a system that may implement arithmetic operations using a digital signal processing (DSP) block that includes a multiplier circuit;
FIG. 2 illustrates an example of the integrated circuit device as a programmable logic device, such as a field-programmable gate array (FPGA);
FIG. 3 is a block diagram of an FPGA digital signal processing (DSP) block that includes a multiplier circuit;
FIG. 4 is a block diagram of one example of the multiplier circuit;
FIG. 5 is a block diagram of a multiplier circuit with partial products all generated according to a radix 8 coding scheme;
FIG. 6 is a block diagram of a multiplier circuit with some partial products generated according to a radix 8 coding scheme and some partial products generated according to a radix 4 coding scheme;
FIG. 7 is a block diagram of a set of 3-2 compressors that compress 5 vectors to 2 vectors;
FIG. 8 is a block diagram of a set of 3-2 compressors that compress 6 vectors to 2 vectors, but have the same logic depth as the set of 3-2 compressors of FIG. 7;
FIG. 9 is a flowchart of a method for generating efficient mixed-radix multiplier circuitry;
FIG. 10 is an example of 12x12 multiplication partial products all generated according to a radix 8 coding scheme;
FIG. 11 is an example of 12x12 multiplication partial products, some of which are generated according to a radix 4 coding scheme and some of which are generated according to a radix 8 coding scheme;
FIG. 12 is a block diagram of an example reduction of the partial products of the example of FIG. 10;
FIG. 13 is a block diagram of an example reduction of mixed-radix partial products;
FIG. 14 is a block diagram of another example reduction of mixed-radix partial products;
FIG. 15 is a block diagram of a single-radix decomposed multiplier;
FIG. 16 is a block diagram of a multiple-radix decomposed multiplier; and
FIG. 17 is a block diagram of a data processing system incorporating the efficient multiplier circuitry.

### DETAILED DESCRIPTION OF SPECIFIC EMBODIMENTS

One or more specific embodiments will be described below. In an effort to provide a concise description of these embodiments, not all features of an actual implementation are described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

When introducing elements of various embodiments of the present disclosure, the articles "a," "an," and "the" are intended to mean that there are one or more of the elements. The terms "comprising," "including," and "having" are intended to be inclusive and mean that there may be additional elements other than the listed elements. Additionally, it should be understood that references to "one embodiment" or "an embodiment" of the present disclosure are not intended to be interpreted as excluding the existence of additional embodiments that also incorporate the recited features.

This disclosure relates to efficient multiplier circuitry that may be used in any suitable integrated circuit that performs an operation that multiplies two values. By way of example, the multiplier circuit may be included in a processor (e.g., a central processing unit (CPU) or a graphics processing unit (GPU)), an application specific integrated circuit (ASIC) (e.g., a specialized artificial intelligence (AI) integrated circuit), or a programmable logic device (PLD) (e.g., in a digital signal processing (DSP) block of a field programmable gate array (FPGA) integrated circuit). A multiplier circuit multiplies two values, a multiplicand (A) and a multiplier (B). To obtain the product of the multiplicand and the multiplier, the multiplier circuit generates partial products representing multiples of the multiplicand based on values of certain components of the multiplier. The partial products are then added together to obtain the full product. Multiplier circuit architectures have been implemented historically using Booth's encoding schemes of a single radix to generate the partial products. These have been used for decades and give good results. Very few new methods have been shown over the past two decades. This disclosure provides a multiplier circuit that, for certain multiplier parameters such as bit depth and die area to be occupied by the multiplier, may provide higher performance and/or lower area using multiple radix partial products.

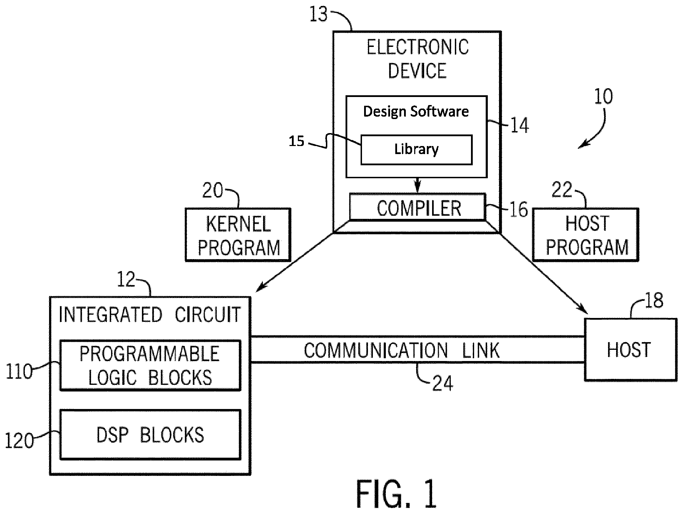

With the foregoing in mind, FIG. 1 illustrates a block diagram of one example of a system 10 that may be used to configure an integrated circuit device 12 with a DSP block that includes the efficient multiplier circuit of this disclosure. However, as mentioned above, the efficient multiplier circuit of this disclosure may be used in any suitable integrated circuit. A designer may desire to implement a system on the integrated circuit device 12 (e.g., a programmable logic device such as a field-programmable gate array (FPGA), an application-specific integrated circuit (ASIC) that includes programmable logic circuitry, or an application-specific integrated circuit (ASIC) that is to be fabricated). The integrated circuit device 12 may include a single integrated circuit, multiple integrated circuits in a package (e.g., a multi-chip module (MCM), a system-in-package (SiP)), or multiple integrated circuits in multiple packages communicating remotely (e.g., via wires or traces). In some cases, the designer may specify a high-level program to be implemented, such as an OPENCL^{®} program that may enable the designer to more efficiently and easily provide programming instructions to configure a set of programmable logic cells for the integrated circuit device 12 without specific knowledge of low-level hardware description languages (e.g., Verilog, very high speed integrated circuit hardware description language (VHDL)). For example, since OPENCL^{®} is quite similar to other high-level programming languages, such as C++, designers of programmable logic familiar with such programming languages may have a reduced learning curve than designers that are required to learn unfamiliar low-level hardware description languages to implement new functionalities in the integrated circuit device 12.

In a configuration mode of the integrated circuit device 12 or in a design phase of the integrated circuit device 12, a designer may use an electronic device 13 (e.g., a computer) to implement high-level designs (e.g., a system user design) using design software 14, such as a version of INTEL^{®} QUARTUS^{®} by INTEL CORPORATION. In some examples, the design software 14 may be used to design a multiplier circuit by selecting various predefined components from a library 15. For example, a multiplier generates many partial products that are added together. Definitions of different addition circuits (e.g., 2-2 compressors, 3-2 compressors) may be stored in the library 15 and selected by the design software 14 to produce a variety of different possible multiplier circuits. Based on the parameters of the multiplier sought by the designer (e.g., the bit depth, the priority of die area taken up by the multiplier, energy constraints, frequency of operation), the design software 14 may consider several different arrangements of encoding and compression and select the arrangement that best meets the parameters of the multiplier sought by the designer.

Additionally or alternatively, the electronic device 13 may use the design software 14 and a compiler 16 to convert a high-level program into a lower-level description (e.g., a configuration program, a bitstream). The compiler 16 may provide machine-readable instructions representative of the high-level program to a host 18 and the integrated circuit device 12. The host 18 may receive a host program 22 that may be implemented by the kernel programs 20. To implement the host program 22, the host 18 may communicate instructions from the host program 22 to the integrated circuit device 12 via a communications link 24 that may be, for example, direct memory access (DMA) communications or peripheral component interconnect express (PCIe) communications. In some embodiments, the kernel programs 20 and the host 18 may enable configuration of circuits including programmable logic blocks 110 and digital signal processing (DSP) blocks 120 on the integrated circuit device 12. The programmable logic blocks 110 may include circuitry and/or other logic elements and may be configurable to implement a variety of functions in combination with digital signal processing (DSP) blocks 120.

The DSP blocks 120 may include circuitry to carry out operations that involve multiplication, such as to perform multiply-accumulate operations or matrix-matrix or matrix-vector multiplication. The integrated circuit device 12 may include many (e.g., hundreds or thousands) of the DSP blocks 120. Additionally, the DSP blocks 120 may be communicatively coupled to another such that data output from one DSP block 120 may be provided to other DSP blocks 120. A DSP block 120 may include hardened arithmetic circuitry that is purpose-built for performing arithmetic operations. The hardened arithmetic circuitry of the DSP blocks 120 may be contrasted with arithmetic circuitry that may be constructed in soft logic in the programmable logic circuitry (e.g., the programmable logic blocks 110). While circuitry for performing the same arithmetic operations may be programmed into the programmable logic circuitry (e.g., the programmable logic blocks 110), doing this may take up significantly more die area, may consume more power, and/or may consume more processing time.

The designer may use the design software 14 to generate and/or to specify a low-level program, such as the low-level hardware description languages described above. Further, in some embodiments, the system 10 may be implemented without a separate host program 22. Thus, embodiments described herein are intended to be illustrative and not limiting.

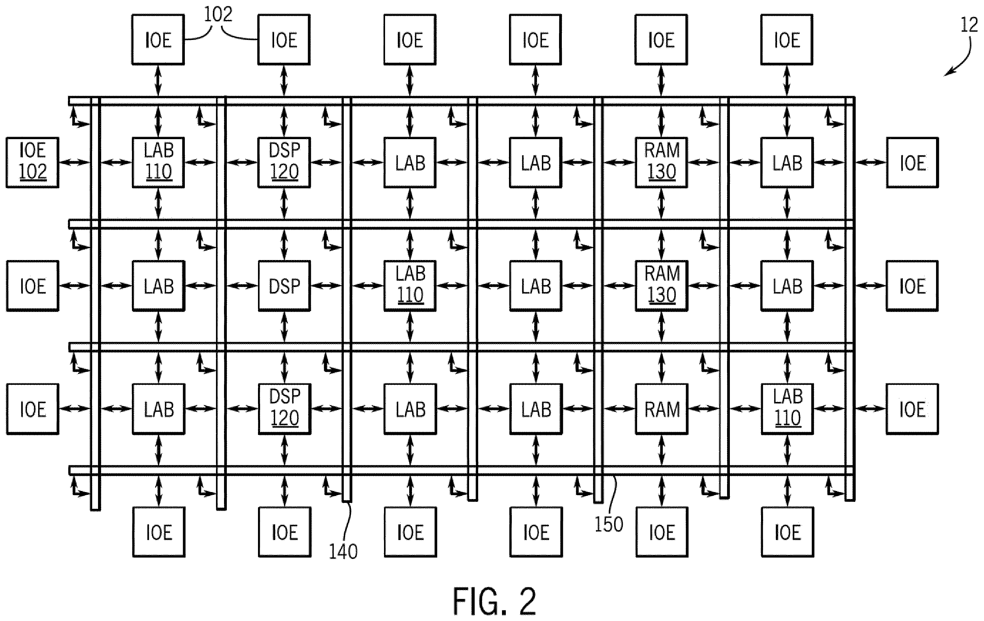

An illustrative example of a programmable integrated circuit device 12 such as a programmable logic device (PLD) that may be configured to implement a circuit design is shown in FIG. 2. As shown in FIG. 2, the integrated circuit device 12 (e.g., a field-programmable gate array integrated circuit die) may include a two-dimensional array of functional blocks, including programmable logic blocks 110 (also referred to as logic array blocks (LABs) or configurable logic blocks (CLBs)) and other functional blocks, such as random-access memory (RAM) blocks 130 and digital signal processing (DSP) blocks 120, for example. Functional blocks such as LABs 110 may include smaller programmable regions (e.g., logic elements, configurable logic blocks, or adaptive logic modules) that receive input signals and perform custom functions on the input signals to produce output signals. LABs 110 may also be grouped into larger programmable regions sometimes referred to as logic sectors that are individually managed and configured by corresponding logic sector managers. The grouping of the programmable logic resources on the integrated circuit device 12 into logic sectors, logic array blocks, logic elements, or adaptive logic modules is merely illustrative. In general, the integrated circuit device 12 may include functional logic blocks of any suitable size and type, which may be organized in accordance with any suitable logic resource hierarchy.

Programmable logic circuitry of the integrated circuit device 12 may include programmable memory elements, which are sometimes referred to as configuration random access memory (CRAM). The memory elements may be loaded with configuration data (also called programming data or configuration bitstream) using input-output elements (IOEs) 102. Once loaded, the memory elements each provide a corresponding static control signal that controls the operation of an associated functional block (e.g., LABs 110, DSP 120, RAM 130, or input-output elements 102).

In one scenario, the outputs of the loaded memory elements are applied to the gates of metal-oxide-semiconductor transistors in a functional block to turn certain transistors on or off and thereby configure the logic in the functional block including the routing paths. Programmable logic circuit elements that may be controlled in this way include parts of multiplexers (e.g., multiplexers used for forming routing paths in interconnect circuits), look-up tables, logic arrays, AND, OR, NAND, and NOR logic gates, pass gates, etc.

The memory elements may use any suitable volatile and/or non-volatile memory structures such as random-access-memory (RAM) cells, fuses, antifuses, programmable read-only-memory memory cells, mask-programmed and laser-programmed structures, combinations of these structures, etc. Because the memory elements are loaded with configuration data during programming, the memory elements are sometimes referred to as configuration memory, configuration random-access memory (CRAM), or programmable memory elements. Programmable logic device (PLD) 100 may be configured to implement a custom circuit design. For example, the configuration RAM may be programmed such that LABs 110, DSP 120, and RAM 130, programmable interconnect circuitry (i.e., vertical channels 140 and horizontal channels 150), and the input-output elements 102 form the circuit design implementation.

In addition, the programmable logic device may have input-output elements (IOEs) 102 for driving signals off of the integrated circuit device 12 and for receiving signals from other devices. Input-output elements 102 may include parallel input-output circuitry, serial data transceiver circuitry, differential receiver and transmitter circuitry, or other circuitry used to connect one integrated circuit to another integrated circuit.

The integrated circuit device 12 may also include programmable interconnect circuitry in the form of vertical routing channels 140 (i.e., interconnects formed along a vertical axis of the integrated circuit 100) and horizontal routing channels 150 (i.e., interconnects formed along a horizontal axis of the integrated circuit 100), each routing channel including at least one track to route at least one wire. If desired, the interconnect circuitry may include pipeline elements, and the contents stored in these pipeline elements may be accessed during operation. For example, a programming circuit may provide read and write access to a pipeline element.

Note that routing topologies other than the topology of the interconnect circuitry depicted in FIG. 1 may be used. For example, the routing topology may include wires that travel diagonally or that travel horizontally and vertically along different parts of their extent as well as wires that are perpendicular to the device plane in the case of three-dimensional integrated circuits, and the driver of a wire may be located at a different point than one end of a wire. The routing topology may include global wires that span substantially all of the integrated circuit device 12, fractional global wires such as wires that span part of the integrated circuit device 12, staggered wires of a particular length, smaller local wires, or any other suitable interconnection resource arrangement.

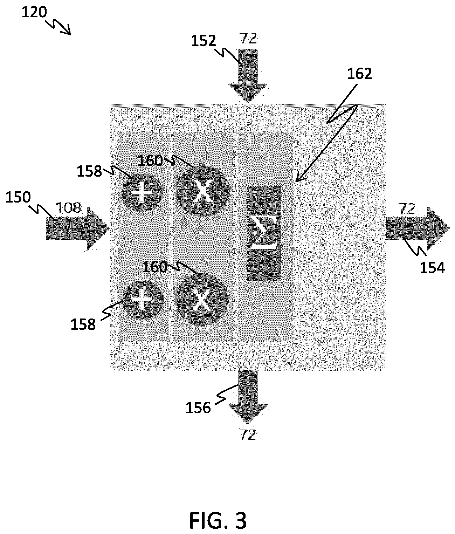

The integrated circuit device 12 may be programmed to perform a wide variety of operations. Indeed, many system designs that may be programmed into the integrated circuit device 12 may leverage the efficiency of performing arithmetic operations using the DSP blocks 120. FIG. 3 shows a block diagram of one example of a DSP Block 120 that may perform multiplication operations (e.g., as often used in digital signal processing). A number of inputs and outputs (e.g., to global FPGA routing) are provided. These signals are limited as connections to global routing are very expensive. Inputs 150 and 152 may feed data of any suitable bit width into the DSP block 120. By way of example, data of up to 108 bits may be fed into the input 150 while data of up to 72 bits may be fed into the input 152. Outputs 154 and 156 likewise may output data of any suitable width out of the DSP block 120. In the illustrated example, the outputs 154 and 156 output data with a width of 72 bits. However, it should be appreciated that any other suitable bit widths may be used (e.g., 64, 96). Pre-adders 158 may be included, as well as several multiplier circuits 160. The multiplier circuits 160 may be of any suitable size (e.g., INT8, INT12, INT18, INT16) and/or may be symmetric (e.g., 8x8) or asymmetric (e.g., 18x19) and summation circuitry 162 may be used to sum or accumulate the results of the pre-adders 158 and/or multiplier circuits 160.

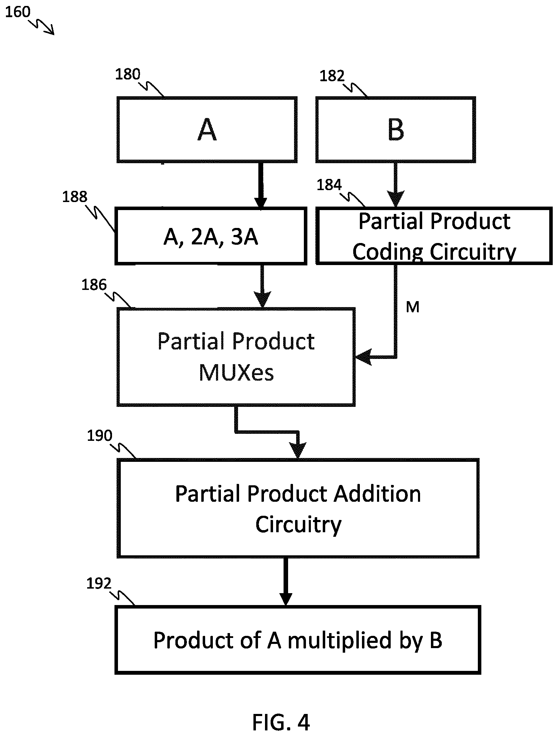

FIG. 4 is a block diagram of one example of an efficient multiplier circuit 160 to multiply a multiplicand (A) 180 with a multiplier (B) 182. The multiplier circuit 160 may employ multiple types of encoding circuitry to generate partial products according to different radices (e.g., Radix 4, Radix 8, Radix 16). Using the partial product coding circuitry 184, the multiplier circuit 160 generates the product of the multiplicand (A) 180 and the multiplier (B) 182 by generating a series of partial products associated with different sets of bits of the multiplier (B) 182 and summing the partial products to obtain a final product. In one example, the multiplier circuit 160 may use partial product coding circuitry 184 to determine a code M. The code M may be provided to partial product multiplexers (MUXes) 186 to produce a partial product. Encodings of different radices may be used to generate different partial products. While using multiple radix partial products may not always provide efficiencies in terms of die area or energy consumption, there are arrangements where this may provide a substantial improvement. For example, in some cases, multiple radix partial products may be added together using fewer logic gates than single-radix partial products. A multiplier that uses fewer logic gates may take up less die area, consume less energy, and/or operate at a higher maximum frequency. While this disclosure describes the use of a radix 4 and radix 8 partial products, encoding schemes of other radices may be used.

To generate each partial product, the partial product coding circuitry 184 may generate a code based on the value of certain sets of bits of the multiplier (B) 182. Shifter and/or tripler circuitry (A, 2A, 3A) 188 may provide the value A by passing the multiplicand (A) 180 or the value 2A by doubling the multiplicand (A) 180 using any suitable circuitry (e.g., by shifting and adding a 0 constant on the least significant bit). Tripler circuitry (3A) may be used to provide the value 3A by tripling (e.g., 2A + A) the multiplicand (A) 180 for radix 8 coding schemes, such as a Booth's Radix 8 coding scheme, or a direct radix 4 coding scheme. Collectively, the partial product coding circuitry 184, partial product multiplexers 186, and shifter and/or tripler circuitry (A, 2A, 3A) 188 may be referred to as partial product generation circuitry. As will be discussed below, the partial product generation circuitry may generate different partial products according to different radix encoding schemes, in which case it may be referred to as mixed-radix partial product generation circuitry. Thereafter, the partial products may be added together using any suitable partial product addition circuitry 190. This may be accomplished, for example, by shift and sign extension, compressor, and carry propagate adder circuitry. Adding the partial products together results in a product 192 representing the value A multiplied by the value B.

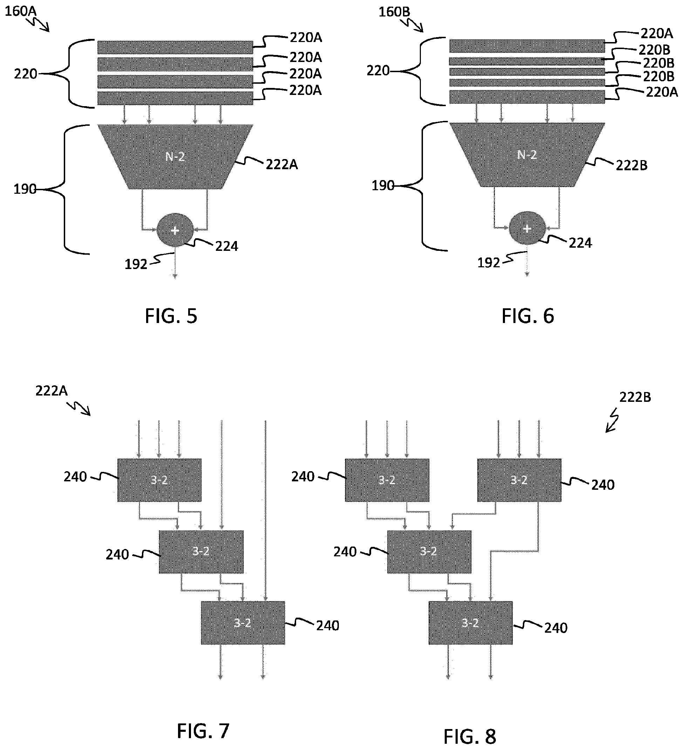

To explain the source of the efficiencies of multiple radix partial products in a multiplier, different arrangements of 12x12 multipliers will be described. In FIG. 5, a multiplier 160A uses Booth's Radix 8 to generate partial products 220, which are illustrated as radix 8 partial products 220A, but any other suitable radix 8 coding scheme may be used instead. In Booth's Radix 8 encoding, partial products are generated based on three adjacent bits, which may be referred to as a tribit, of the multiplier (B) 182. Thus, for 12x12 multiplication, this results in four radix 8 partial products 220A. The partial products 220 are added together by the partial product addition circuitry 190, shown here to include N-2 compression circuitry 222A (e.g., a Wallace tree, a Dadda tree) designed to compress the four radix 8 partial products 220A and the result added in a carry propagate adder 224 to generate the product 192.

FIG. 6 illustrates a multiplier 160B that uses radix 8 (e.g., Booth's Radix 8 or any other suitable radix 8 coding scheme) and radix 4 (e.g., Booth's Radix 4 or any other suitable radix 4 coding scheme) to generate mixed-radix partial products 220. Here, radix 8 is used for the 3 most significant bits (MSBs) and the 3 least significant bits (LSBs) of the multiplier (B) 182, producing two radix 8 partial products 220A. Radix 4 is used for the middle 6 bits of the multiplier (B) 182. In Booth's Radix 4 encoding, partial products are generated based on two adj acent bits, which may be referred to as a dibit, of the multiplier (B) 182. Thus, using Booth's Radix 4 on the middle 6 bits of the multiplier (B) 182 produces three radix 4 partial products 220B. In total, there are five partial products 220 in this example, but there are many different combinations possible for any given multiplier size. The partial products 220 are added together by the partial product addition circuitry 190, shown here to include N-2 compression circuitry 222A (e.g., a Wallace tree, a Dadda tree) designed to compress the two radix 8 partial products 220A and the three radix 4 partial products 220B, the results of which are added in a carry propagate adder 224 to generate the product 192.

Although the mixed-radix multiplier 160B of FIG. 6 includes more partial products than the single-radix multiplier 160A of FIG. 5 (as well as different types of partial products where some common constructs like the tripler (3A) cannot be shared because it is used by Booth's Radix 8 but not Booth's Radix 4), the mixed-radix multiplier 160B may in fact be smaller and/or faster (Tpd) than the single-radix multiplier 160A. Indeed, this comparison may be seen between FIG. 7, which illustrates compression circuitry that compresses 5 values to 2 values, and FIG. 8, which illustrates compression circuitry that compresses 6 values to 2 values. In FIG. 7, three 3-2 compressors 240 compress a vector of 5 values to 2 values. In FIG. 8, four 3-2 compressors 240 compress a vector of 6 values to 2 values. Yet while the example of FIG. 8 includes an additional 3-2 compressor 240, if the partial products are much smaller, there may be an overall improvement in area and/or speed.

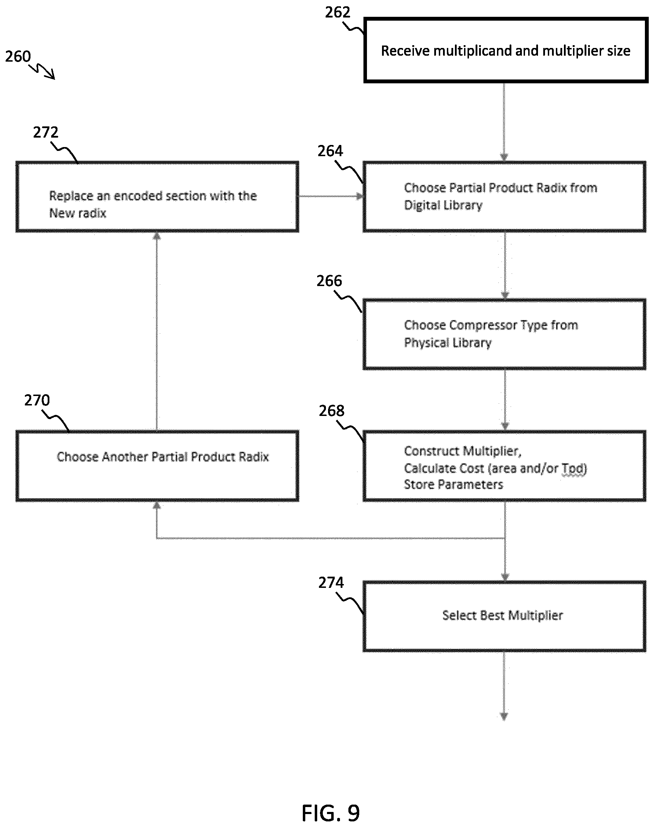

FIG. 9 illustrates a flowchart 260 of a method to design a mixed-radix multiplier 160. The method 260 may be carried out by any suitable processing system (e.g., the design software 14 running on the electronic device 13). Many aspects of the multiplier 160 may be selected based the size of the multiplicand (A) or multiplier (B) that may be received at block 262 and/or a prioritization on speed and/or die area. Based on these values, several possible multipliers may be generated and stored according to blocks 264, 266, 268, 270, and 272. At block 264, a multiplier partial product encoding is chosen. This may be described in an IP (RTL) library. At block 266, a compressor tree type and components (e.g., from a target technology vendor's library) is chosen. At block 268, the multiplier is built and the parameters (e.g., area and speed) are determined and stored. At block 270, A new radix is chosen, supported by IP from the digital library. At block 272, one or more of the current partial product encoders are replaced with the new radix. After block 272, the process may repeat as many times as desired (e.g., a certain number of times, until all possible arrangements have been considered) as different possible multiplier designs are generated and parameters are stored. For example, the parameters may indicate an area of the die to be used by the multiplier, an expected energy consumption of the multiplier, or a cost function value corresponding to a combination (e.g., balance) of parameters such as area or energy consumption. After the last multiplier design is generated and its parameters are stored, at block 274, the multiplier design with the most desirable parameters (e.g., area and/or speed, lowest cost function value) may be selected.

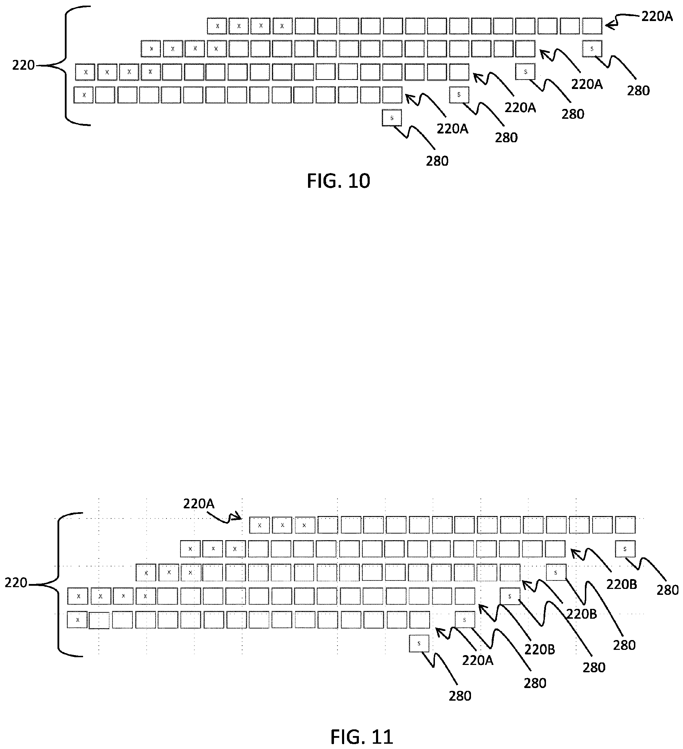

A mixed-radix multiplier produces different partial products that may be reduced (e.g., added together) in different ways in different multipliers. FIGS. 10 and 11 illustrate a comparison of partial products from a 12x12 multiplier with only radix 8 encoding (FIG. 10) and partial products from a 12x12 multiplier with radix 8 and radix 4 encoding (FIG. 11). As shown in FIG. 10, applying radix 8 encoding to groups of three bits to a 12-bit multiplier (B) value results in four radix 8 partial products 220A. Sign extensions marked with "x" are illustrated for each partial product. Sign bit 280 positions, which are used for encoding the negatives (2's complement) of the multiplicand (A), add one to the partial product depth to result in a 5-level depth.

For FIG. 11, radix 8 encoding has been used for the three most significant bits (MSBs) and the three least significant bits (LSBs), resulting in radix 8 partial products 220A as the first and last radix 8 partial products. Radix 4 encoding has been used for the six middle bits, resulting in three radix 4 partial products 220B in between the radix 8 partial products 220A. Note that the offset between these partial products is 2 because of the radix 4 encoding, which generates partial products with the multiplicand (A) based on two bits of the multiplier (B). Note that the 5 partial products have an additional vector because of the sign bits 280, which results in a 6-level depth.

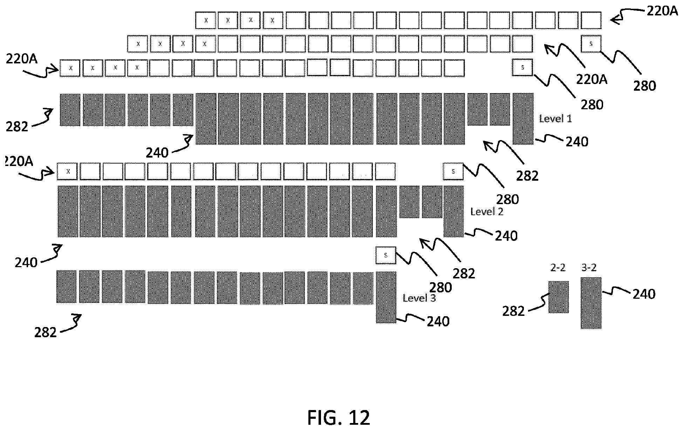

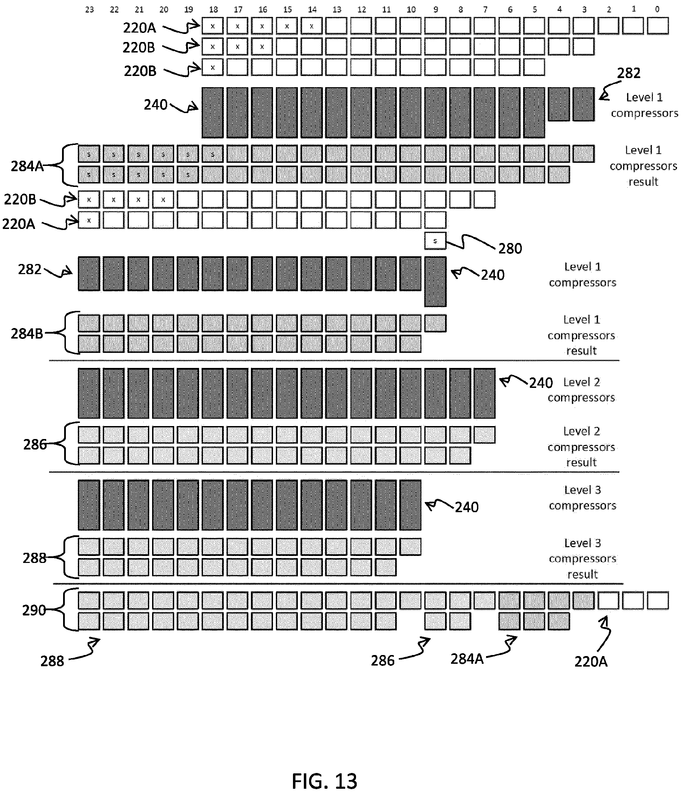

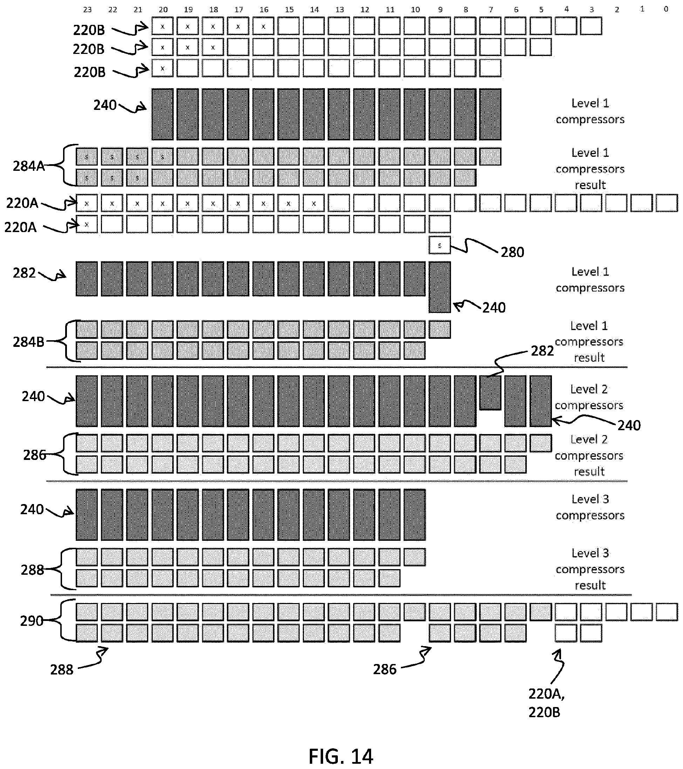

The resulting partial products are reduced (added together) to obtain the overall product of the multiplicand (A) and the multiplier (B). FIG. 12 illustrates one reduction of the radix 8 partial products 220A of FIG. 10, while FIGS. 13 and 14 illustrate different reductions of the mixed-radix partial products of FIG. 11. These are meant to be non-limiting examples of the kinds of multiplier structures that may be obtained and to illustrate various ways in which mixed-radix multipliers may more efficiently reduce mixed-radix partial products while obtaining the same ultimate product of the multiplicand (A) and multiplier (B).

FIG. 12 shows one reduction of the partial products of FIG. 10, obtained using Booth's radix 8 encoding. First, three of the radix 8 partial products 220A are compressed using 3-2 compressors 240, which are a common library element (e.g., 10nm libraries of some manufacturers have optimized 3-2 compressors, but not higher level compressors). To save area, 2-2 compressors 282 may be used in some columns. Even if built out of discrete gates, a 2-2 compressor 282 would still be smaller than a 3-2 compressor 240. The output of this level would be 2 vectors, which is then compressed again with the fourth radix 8 partial product 220A, again resulting in 2 vectors. Finally, the remaining sign bit 280 needs to be added into the vectors, which can mostly be done with 2-2 compressors 282, but we still have a 3-level reduction tree illustrated as Level 1, Level 2, and Level 3.

FIG. 13 shows one example of a reduction of the partial products 220A and 220B from a mixed radix 12x12 multiplier. An LSB radix 8 partial product 220A is compressed with the first two radix 4 partial products 220B. This occurs at the reduction level shown as Level 1 and produces a result 284A. At the same time, the two most significant partial products, a radix 4 partial product 220B and radix 8 partial product 220A, are compressed with the most significant sign bit 280 (which can be done with 2-2 compressors 282). This also occurs at the reduction level shown as Level 1. This result 284B will be available before the 3-2 compression of Level 1 of the reduction. The second level (Level 2) compression will use 3-2 compressors 240 on three of the four vectors from the first level (Level 1) and produces results 286, followed by a third level of compression using 3-2 compressors 240 (Level 3) that produces results 288. Ultimately, a final result 290 is two vectors that include the results 288, 286, 284A, and some of the LSB radix partial product 220A. In sum, there are 3 levels of compression, which is the same as the radix 8 case illustrated in FIG. 12. The third level (Level 3) in the mixed-radix case of FIG. 13 uses 3-2 compressors 240, which are slower than the 2-2 compressors 282 of the third level (Level 3) of the radix 8 case of FIG. 12, but this may be offset by the simpler partial product encoding for the middle bits in the mixed-radix case. In other words, in some cases, partial product encoding circuitry to produce radix 4 partial products 220B may be more efficient than partial product encoding circuitry to produce radix 8 partial products 220A.

But the same partial products 220 can be used in a different reduction, starting with the middle bits, as shown in FIG. 14. Here, the three radix 4 partial products 220B are compressed first at a first reduction level (Level 1) to produce results 284A. The radix 4 partial products 220B, which encode 2 bits of the multiplier (B) at a time, are generated much more quickly than the radix 8 partial products 220B, which encode 3 bits of the multiplier (B) at a time. As a consequence, the results 284A of the compression of the three radix 4 partial products 220B will be available before the radix 8 partial products 220A themselves. The two radix 8 partial products 220A are compressed with the sign bit 280 of the most significant radix 4 partial products 220B at the same reduction level (Level 1). This is largely accomplished using a small number of 2-2 compressors 282, so will be small and fast. Compressing the remaining 4 vectors is smaller in the second and third reduction levels (Level 2 and Level 3) to produce results 286 and 288 and has a shorter depth than the original radix 8 compression shown in FIG. 12 to produce a final result 290, which includes components of the results 288, 286, and least significant bit partial products 220A and 220B. This shows that, in at least some cases, mixed-radix multipliers may use fewer gates for compression (addition) of partial products and/or may be less complex, potentially saving area and energy, compared to single-radix multipliers. Indeed, the mixed-radix examples of FIGS. 13 and 14 have a depth equal to the minimum depth to reduce partial products of the single-radix case of FIG. 12 using the same compression elements (e.g., 2-2 compressors and 3-2 compressors), while exhibiting other benefits (e.g., potential savings in area or complexity in the partial product addition circuitry for reducing the partial products or in the partial product generation circuitry).

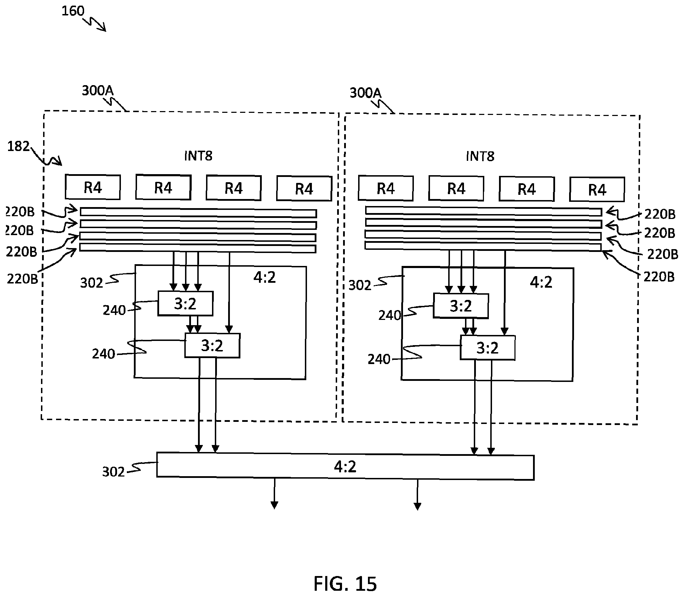

One use case for mixed-radix multipliers is multiplier decomposition. Larger multipliers may be decomposed into several smaller multipliers having partial products that may be reduced separately. FIG. 15 illustrates one example of a single-radix INT16 multiplier 160 that is decomposed into two separate INT8 multipliers 300A. Collectively, the multiplier 160 may receive a multiplier value 182 of 16 bits. Each multiplier 300A may handle 8 bits. In the example of FIG. 15, four dibits of the multiplier value 182 processed by radix 4 encoders produce four radix 4 partial products 220B. A reduction to two vectors from these four partial products may be accomplished by a 4:2 compressor. A 4:2 compressor may be composed of two 3:2 compressors 240 as illustrated in FIG. 15, which has a depth of two levels. The resulting two vectors from each separate multiplier 300A may be compressed together in another 4:2 compressor 302 to produce the final two vectors that may be added together to obtain a product of the multiplier 160 of FIG. 15. Thus, the reduction for the overall multiplier 160 has a logical depth of four levels.

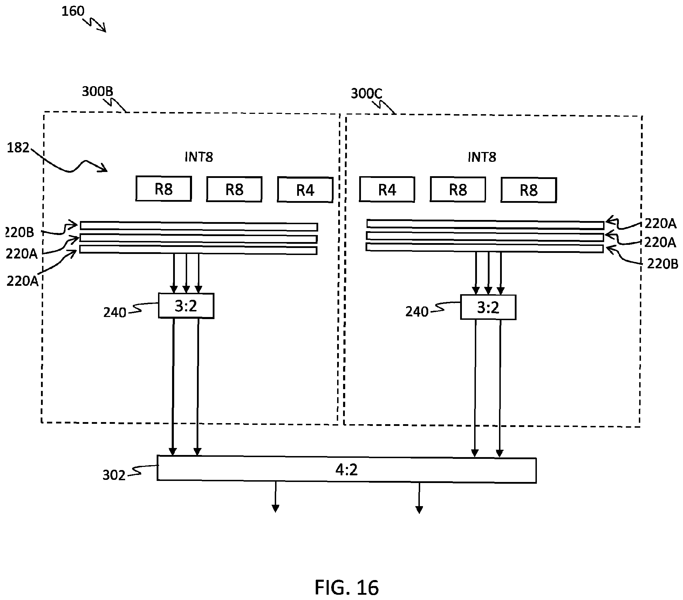

In contrast, as shown in FIG. 16, the same size multiplier 160 may be decomposed into two mixed-radix multipliers 300B and 300C, which may be able to perform reduction with fewer levels of logical depth. As in the example mentioned above with reference to FIG. 15, the multiplier 160 of FIG. 16 is an INT16 multiplier 160 that is decomposed into two separate INT8 multipliers 300B and 300C. Collectively, the multiplier 160 may receive a multiplier value 182 of 16 bits. Each multiplier 300B or 300C may handle 8 bits. In the example of FIG. 16, two bits of the multiplier value 182 are processed by a radix 4 encoder and two sets of three bits are processed by radix 8 encoders to produce one radix 4 partial product 220B and two radix 8 partial products 220A. As a consequence, there are three partial products in FIG. 16 rather than the four partial products of FIG. 15. Thus, a reduction to two vectors from these three partial products of FIG. 16 may be accomplished by one 3:2 compressor. The resulting two vectors from each separate multiplier 300B and 300C may be compressed together in a 4:2 compressor 302 to produce the final two vectors that may be added together to obtain a product of the multiplier 160 of FIG. 16. Thus, the reduction for the overall multiplier 160 has a logical depth of three levels.

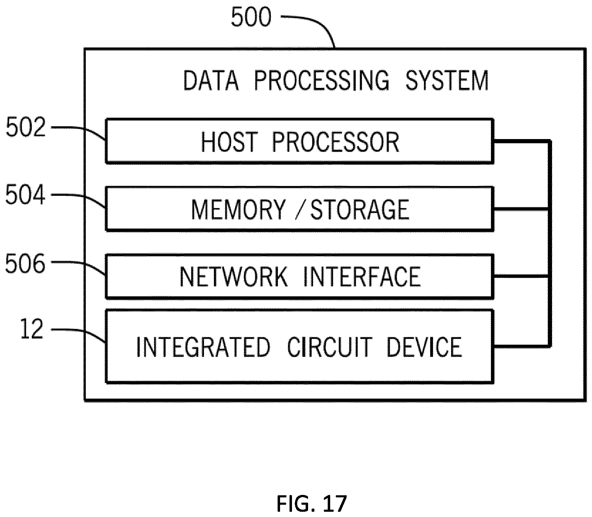

An integrated circuit including the multiplier circuitry of this disclosure may be a component included in a data processing system, such as a data processing system 500, shown in FIG. 17. The data processing system 500 may include the integrated circuit system 12 (e.g., a programmable logic device), a host processor 502, memory and/or storage circuitry 504, or a network interface 506. The multiplier circuitry of this disclosure may be part of the integrated circuit system 12 (e.g., a programmable logic device), the host processor 502, the memory and/or storage circuitry 504, or the network interface 506, or another integrated circuit such as a graphics processing unit (GPU) or AI application specific integrated circuit (ASIC). The data processing system 500 may include more or fewer components (e.g., electronic display, user interface structures, application specific integrated circuits (ASICs)). The integrated circuit device 12 may be used to efficiently implement a symmetric FIR filter or perform complex multiplication. The host processor 502 may include any of the foregoing processors that may manage a data processing request for the data processing system 500 (e.g., to perform encryption, decryption, machine learning, video processing, voice recognition, image recognition, data compression, database search ranking, bioinformatics, network security pattern identification, spatial navigation, cryptocurrency operations, or the like). The memory and/or storage circuitry 504 may include random access memory (RAM), read-only memory (ROM), one or more hard drives, flash memory, or the like. The memory and/or storage circuitry 504 may hold data to be processed by the data processing system 500. In some cases, the memory and/or storage circuitry 504 may also store configuration programs (e.g., bitstreams, mapping function) for programming the integrated circuit device 12. The network interface 506 may allow the data processing system 500 to communicate with other electronic devices. The data processing system 500 may include several different packages or may be contained within a single package on a single package substrate. For example, components of the data processing system 500 may be located on several different packages at one location (e.g., a data center) or multiple locations. For instance, components of the data processing system 500 may be located in separate geographic locations or areas, such as different cities, states, or countries.

The data processing system 500 may be part of a data center that processes a variety of different requests. For instance, the data processing system 500 may receive a data processing request via the network interface 506 to perform encryption, decryption, machine learning, video processing, voice recognition, image recognition, data compression, database search ranking, bioinformatics, network security pattern identification, spatial navigation, digital signal processing, or other specialized tasks.

While the embodiments set forth in the present disclosure may be susceptible to various modifications and alternative forms, specific embodiments have been shown by way of example in the drawings and have been described in detail herein. However, it should be understood that the disclosure is not intended to be limited to the particular forms disclosed. The disclosure is to cover all modifications, equivalents, and alternatives falling within the spirit and scope of the disclosure as defined by the following appended claims.

The techniques presented and claimed herein are referenced and applied to material objects and concrete examples of a practical nature that demonstrably improve the present technical field and, as such, are not abstract, intangible or purely theoretical. Further, if any claims appended to the end of this specification contain one or more elements designated as "means for [perform]ing [a function] ..." or "step for [perform]ing [a function]...", it is intended that such elements are to be interpreted under 35 U.S.C. 112(f). However, for any claims containing elements designated in any other manner, it is intended that such elements are not to be interpreted under 35 U.S.C. 112(f).

### Example Embodiments

EXAMPLE EMBODIMENT 1. Multiplier circuitry to multiply a multiplicand value with a multiplier value, the multiplier circuitry comprising:
input circuitry to receive the multiplicand value and the multiplier value; and
mixed-radix partial product generation circuitry to generate partial products that include a first radix partial product according to a first radix coding and a second radix partial product according to a second radix coding; and
partial product addition circuitry to add the partial products to generate a product of the multiplicand value and multiplier value.

EXAMPLE EMBODIMENT 2. The multiplier circuitry of example embodiment 1, wherein the mixed-radix partial product generation circuitry comprises partial product coding circuitry to encode a first set of bits of the multiplier value according to the first radix coding and encode a second set of bits of the multiplier value according to the second radix coding.

EXAMPLE EMBODIMENT 3. The multiplier circuitry of example embodiment 2, wherein the first radix coding comprises a radix 8 encoding and the second radix coding comprises a radix 4 encoding.

EXAMPLE EMBODIMENT 4. The multiplier circuitry of example embodiment 2, wherein the first radix coding comprises a form of Booth's radix 8 encoding.

EXAMPLE EMBODIMENT 5. The multiplier circuitry of example embodiment 2, wherein the second radix coding comprises a form of Booth's radix 4 encoding.

EXAMPLE EMBODIMENT 6. The multiplier circuitry of example embodiment 1, wherein the partial product addition circuitry comprises a number of levels less than or equal to a minimum depth to reduce partial products that would be produced by first radix single-radix partial product generation circuitry on other multiplicand values and other multiplier values of the same bit depth as the multiplicand value and the multiplier value using only the first radix coding.

EXAMPLE EMBODIMENT 7. The multiplier circuitry of example embodiment 6, wherein the number of levels is less than or equal to a minimum depth to reduce partial products that would be produced by second radix single-radix partial product generation circuitry on other multiplicand values and other multiplier values of the same bit depth as the multiplicand value and the multiplier value using only the second radix coding.

EXAMPLE EMBODIMENT 8. The multiplier circuitry of example embodiment 1, wherein the multiplier circuitry is decomposed into at least two smaller multiplier circuits, wherein a first of the at least two smaller multiplier circuits comprises a first portion of the mixed-radix partial product generation circuitry and a first portion of the partial product addition circuitry and a second of the at least two smaller multiplier circuits comprises a second portion of the mixed-radix partial product generation circuitry and a second portion of the partial product addition circuitry.

EXAMPLE EMBODIMENT 9. The multiplier circuitry of example embodiment 1, wherein the partial product addition circuitry is to reduce the partial products in an order different from least significant to most significant.

EXAMPLE EMBODIMENT 10. The multiplier circuitry of example embodiment 1, wherein the partial product addition circuitry is to reduce a first set of the partial products while a second set of the partial products are still being generated.

EXAMPLE EMBODIMENT 11. An article of manufacture comprising one or more tangible, non-transitory, machine-readable media comprising instructions that, when executed by a data processing system, result in operations comprising:
generating a set of possible multiplier designs that comprises at least one mixed-radix multiplier design;
selecting a multiplier design from among the set of possible multiplier designs; and
generating a circuit design that includes the selected multiplier design.

EXAMPLE EMBODIMENT 12. The article of manufacture of example embodiment 11, wherein generating the set of possible multiplier designs comprises generating multiple multiplier designs having different respective partial product coding circuitry designs.

EXAMPLE EMBODIMENT 13. The article of manufacture of example embodiment 11, wherein generating the set of possible multiplier designs comprises generating multiple multiplier designs having different respective partial product addition circuitry designs.

EXAMPLE EMBODIMENT 14. The article of manufacture of example embodiment 13, wherein generating the set of possible multiplier designs comprises generating multiple multiplier designs having a common mixed-radix partial product coding circuitry designs but different respective partial product addition circuitry designs.

EXAMPLE EMBODIMENT 15. The article of manufacture of example embodiment 11, wherein the instructions result in operations comprising calculating a cost function value for respective multiplier designs of the multiplier designs and wherein selecting the multiplier design from among the set of possible multiplier designs comprises selecting the multiplier design with the lowest cost function value.

EXAMPLE EMBODIMENT 16. The article of manufacture of example embodiment 15, wherein the cost function considers area or speed, or both area and speed.

EXAMPLE EMBODIMENT 17. An integrated circuit comprising:
mixed-radix partial product coding circuitry to generate partial product codes according to a plurality of radix coding schemes as applied to bits of a multiplier value;
partial product multiplexers to select a multiple of a multiplicand value based on the partial product codes to generate a set of partial products; and
partial product addition circuitry to add the set of partial products to generate a product of the multiplicand value and multiplier value.

EXAMPLE EMBODIMENT 18. The integrated circuit of example embodiment 17, wherein the mixed-radix partial product coding circuitry is to generate a first partial product code for a first set of the bits of the multiplier value according to a first radix coding scheme of the plurality of radix coding schemes and to generate a second partial product code for a second set of the bits of the multiplier value according to a second radix coding scheme of the plurality of radix coding schemes, wherein the first set of bits is of a different number than the second set of bits.

EXAMPLE EMBODIMENT 19. The integrated circuit of example embodiment 17, wherein the partial product addition circuitry comprises a compression tree composed of compressors no larger than 3-2 compressors.

EXAMPLE EMBODIMENT 20. The integrated circuit of example embodiment 17, wherein the integrated circuit comprises a processor, an application specific integrated circuit (ASIC), or a programmable logic device, or any combination thereof.

## Claims

1. Multiplier circuitry to multiply a multiplicand value with a multiplier value, the multiplier circuitry comprising:
input circuitry to receive the multiplicand value and the multiplier value; and mixed-radix partial product generation circuitry to generate partial products that include a first radix partial product according to a first radix coding and a second radix partial product according to a second radix coding; and
partial product addition circuitry to add the partial products to generate a product of the multiplicand value and multiplier value.

2. The multiplier circuitry of claim 1, wherein the mixed-radix partial product generation circuitry comprises partial product coding circuitry to encode a first set of bits of the multiplier value according to the first radix coding and encode a second set of bits of the multiplier value according to the second radix coding.

3. The multiplier circuitry of claim 2, wherein the first radix coding comprises a radix 8 encoding and the second radix coding comprises a radix 4 encoding.

4. The multiplier circuitry of claim 2 or 3, wherein the first radix coding comprises a form of Booth's radix 8 encoding.

5. The multiplier circuitry of any of claims 2-4, wherein the second radix coding comprises a form of Booth's radix 4 encoding.

6. The multiplier circuitry of any one of the preceding claims, wherein the partial product addition circuitry comprises a number of levels less than or equal to a minimum depth to reduce partial products that would be produced by first radix single-radix partial product generation circuitry on other multiplicand values and other multiplier values of the same bit depth as the multiplicand value and the multiplier value using only the first radix coding.

7. The multiplier circuitry of claim 6, wherein the number of levels is less than or equal to a minimum depth to reduce partial products that would be produced by second radix single-radix partial product generation circuitry on other multiplicand values and other multiplier values of the same bit depth as the multiplicand value and the multiplier value using only the second radix coding.

8. The multiplier circuitry of any one of the preceding claims, wherein the multiplier circuitry is decomposed into at least two smaller multiplier circuits, wherein a first of the at least two smaller multiplier circuits comprises a first portion of the mixed-radix partial product generation circuitry and a first portion of the partial product addition circuitry and a second of the at least two smaller multiplier circuits comprises a second portion of the mixed-radix partial product generation circuitry and a second portion of the partial product addition circuitry.

9. The multiplier circuitry of any one of the preceding claims, wherein the partial product addition circuitry is to reduce the partial products in an order different from least significant to most significant.

10. The multiplier circuitry of any one of the preceding claims, wherein the partial product addition circuitry is to reduce a first set of the partial products while a second set of the partial products are still being generated.

11. An article of manufacture comprising one or more tangible, non-transitory, machine-readable media comprising instructions that, when executed by a data processing system, result in operations comprising:
generating a set of possible multiplier designs that comprises at least one mixed-radix multiplier design;
selecting a multiplier design from among the set of possible multiplier designs; and
generating a circuit design that includes the selected multiplier design.

12. The article of manufacture of claim 11, wherein generating the set of possible multiplier designs comprises generating multiple multiplier designs having different respective partial product coding circuitry designs.

13. The article of manufacture of claim 11 or 12, wherein generating the set of possible multiplier designs comprises generating multiple multiplier designs having different respective partial product addition circuitry designs.

14. The article of manufacture of claim 13, wherein generating the set of possible multiplier designs comprises generating multiple multiplier designs having a common mixed-radix partial product coding circuitry designs but different respective partial product addition circuitry designs.

15. The article of manufacture of any one of claims 11-14, wherein the instructions result in operations comprising calculating a cost function value for respective multiplier designs of the multiplier designs and wherein selecting the multiplier design from among the set of possible multiplier designs comprises selecting the multiplier design with the lowest cost function value.
